(19) Europäisches Patentamt
European Patent Office
Office européen des brevets

(11) **EP 3 059 856 A1**

(12) **EUROPEAN PATENT APPLICATION**

(43) Date of publication:
**24.08.2016 Bulletin 2016/34**

(51) Int Cl.:
**_H02S 50/00_** _(2014.01)_

(21) Application number: **16155517.2**

(22) Date of filing: **12.02.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **17.02.2015 JP 2015028265**

(71) Applicant: **Onamba Co., Ltd.**
**Osaka-shi, Osaka 537-0001 (JP)**

(72) Inventors:
• **Haku, Choyu**
**Osaka, Osaka 537-0001 (JP)**

• **Gotoh, Takayuki**
**Osaka, Osaka 537-0001 (JP)**
• **Suzuki, Tsuneyuki**
**Osaka, Osaka 537-0001 (JP)**
• **Fujimoto, Yoshiya**
**Osaka, Osaka 537-0001 (JP)**
• **Katoh, Keisuke**
**Osaka, Osaka 537-0001 (JP)**
• **Hashimoto, Tsukasa**
**Osaka, Osaka 537-0001 (JP)**

(74) Representative: **Patentanwälte**
**Ruff, Wilhelm, Beier, Dauster & Partner mbB**
**Kronenstraße 30**
**70174 Stuttgart (DE)**

(54) **METHOD FOR PREDICTING A FUTURE TIMING OF LOWERING OF A CURRENT VALUE OR POWER GENERATION QUANTITY OF A SOLAR POWER GENERATION SYSTEM**

(57) A method for predicting a future timing when the current value or power generation quantity of a part of a solar power generation system will have been lowered by a specific level from the current value or power generation quantity thereof at present includes gaining data on the current value or power generation quantity, which is a prediction target. Also data on the current value or power generation quantity of a different and comparative part having one or more relevancies with the prediction target about a physically positional adjacent relationship, a physically positional interval relationship, a similarity of past data values, and/or a structural similarity is gained. An absolute degree of grey incidence from these gained data is calculated, wherein a digital grey predictive model to calculate, from the calculated absolute degree of grey incidence, the degree of incidence between data at present on the prediction target and data at present on the comparative target, and the degree of incidence between future data on the prediction target and future data on the comparative target is used. A future timing when the degree of incidence between the future data will have been lowered by a specific level from the degree of incidence between the data at present, in the prediction target compared with the comparative target is indicated.

[Fig. 1]

**Description**

Technical Field of the Invention

The present invention relates to a method for predicting a future timing when there will be caused a situation that in a solar cell module or a solar cell string (referred to also as a module or a string, respectively), or a power conditioner of a solar power generation system, the current value or power generation quantity thereof will have been lowered by a specific level. This method makes it possible to know an appropriate timing when a maintenance of the solar power generation system is to be performed, and attain a planned maintenance.

Prior Art

In order to use solar energy effectively, solar power generation systems have already been spreading wherein a large number of solar cell panels are arranged. About the solar power generation systems, various systems exist which range from small-scale systems each set on a house roof to large-scale systems each having a power generation quantity of 1 megawatt or more that can supply the regional electricity.

In a large-scale system, a plurality of solar cell modules are connected to each other in series so as to constitute each solar cell string. Furthermore, the plurality of solar cell strings are connected in parallel into power conditioners which are each a controller of the solar power generation system. In the power conditioners, the DC electric power from solar cell strings is converted and controlled to AC electric power, so that a final electric power generation output is obtained. For example, in order to monitor data, each of the power conditioners is connected to a network, and further connected to a remote data-collecting/monitoring server through the Internet. The data about power generation, such as current value and power generation quantity, are sent to the server in real time. At the server, the respective power generation situations of the power conditioners are monitored. When an abnormality is occurred, a notice of the abnormality is immediately given to a solar power generation system manager.

In any solar power generation system, the current value or power generation quantity in module/string/power conditioner may lower due to an error in a work for setting up the system, a defect of parts thereof, a deterioration with age based on use over many years, a trouble caused by thunder or the like, or an external factor such as weather, a maintenance thereof or a shadow. When the lowering of the current value or power generation quantity is caused by any temporary external factor, the lowering may be ignored. However, when it is caused by a trouble, it is desired to repair or exchange the corresponding module(s)/string(s)/power conditioner(s) as soon as possible.

However, in a power generation system composed of many modules/strings/power conditioners, before a trouble of module/string/power conditioner arrived its breakdown level finally, several weeks or months maybe needed. During this period, the situation gradually deteriorates. Simultaneously, a power generation loss increases with the elapse of time. That means a loss of several hundreds of thousands of yens or several millions of yens per MW in some cases. Furthermore, because the earlier chance for preventing the lighter trouble is overlooked, the abnormal module, string or power conditioner may be led into a serious and irreparable trouble (such as a fire) from an initial light trouble which can be recovered by a simple maintenance. As a result, the facilities may be completely damaged, which leads to the unattainability of power generation. The recovery cost may be caused by the exchange of the facilities, and costs for the facility-exchange and labor costs may expand.

A conventional detection of an abnormality of a solar power generation system is generally made in the unit of solar cell module which constitutes a solar cell panel, or in the unit of a solar cell string which is composed of a plurality of solar cell modules or power conditioner after a trouble has been already occurred obviously.

For example, according to WO 2011/101916 A1, the respective current values of plural modules or strings are measured, and then a comparison is made between each of the measured current values of the modules or strings and the average of the measured current values. When there is a module or string giving a measured current value continuing to lower than the average of the measured current values by a predetermined proportion or more even when a predetermined period elapses, the module or string is detected as troubled or failed one. The method in WO 2011/101916 A1 is to some extent effective for detecting an existing trouble. However, in the above method, it is impossible to detect a possibility of trouble or lowering in power generation quantity or some other factor in a module or some other that is normal at present but may be abnormal in the future, or to report the possibility beforehand.

According to JP-A No. 2013-93430, abnormality determining means presumes information on a power generation to be gained on the basis of solar radiation quantity information and temperature information, and then determines that an abnormality is occurred in the solar power generating panel when information on an actually measured power generation is lower than the presumed power generation information by a predetermined abnormality determining threshold.

JP-A No. 2012-156343 suggests a solar power generation system including: a solar panel having solar cells connected in series to each other; a voltage detecting unit for detecting the output voltage value while the panel is generating electricity; a current detecting unit for detecting the output current value while the panel is generating electricity; an outside environment measuring unit for gaining outside environment data showing the environment of the outside; a characteristic calculating unit for calculating a characteristic of the solar panel in the abnormal state, and a threshold for detecting the abnormal state, using the output voltage value, the output current value, and the outside environment data; and an abnormality detecting unit in which the characteristic of the solar panel in the abnormal state, and the threshold are used to detect an actual abnormal state of the solar panel. WO 2012/081116 A1 suggests a solar power generation system including a solar cell string having a plurality of solar cell modules connected in series to each other, and a power conditioner, and further including weather state determining means for determining whether the present weather state is cloudy or fine, means for changing an output-operating point of the solar cell string, and detecting means for detecting trouble of the solar cell modules, wherein the detecting means detects the trouble of the solar cell modules when it is determined that the weather situation is cloudy and when a discontinuous point is generated in the differential property of the output electric power or output current of the solar cell string at the time of changing the operating point of the solar cell string.

In the same manner as WO 2011/101916 A1, JP-A No. 2013-93430, JP-A No. 2012-156343 and WO 2012/081116 A1 described above are each an invention of attempting to detect an already caused trouble, and never suggest any invention of detecting a possibility that in the future a module or some other may be troubled or may be lowered in power generation quantity or some other factor, or of predicting a timing of the trouble or lowering. As described hereinbefore, any conventional solar power generation system cannot predict a timing of the generation of an impermissible trouble or abnormality in the future. Thus, in the present situation, an appropriate maintenance timing in the future cannot be precisely suggested.

Problem that the Invention is to Solve

In light of the present situation of these conventional techniques, the present invention has been made. An object thereof is to provide a simple method for predicting a future timing when, in a module/string/power conditioner of a solar power generation system, the current value or power generation quantity thereof will lower by a specific level compared with the value or quantity at present. The present invention makes it possible, in particular, to change an abnormality detection of a solar power generation system from an after-the-fact detection type of detecting an already generated abnormality to a previously-predicting type of detecting a possibility of a future abnormality before an actual trouble is caused. Thus, the present invention makes it possible to advise an appropriate maintenance timing of the solar power generation system precisely in accordance with this previous prediction.

Means for Solving the Problem

The inventors have made eager investigations to attain this object and paid attention to a relevancy between mutual data on a prediction target module/string/power conditioner and a different and comparative module/string/power conditioner having one or more specific relevancies about a physically positional adjacent relationship, a physically positional interval relationship, a similarity of past power generation quantity or current value and other past data values, and/or a structural similarity. Then, the inventors have found out that before the prediction target is seriously troubled or remarkably lowered in power generation quantity, an appropriate maintenance timing of this prediction target can be precisely advised by: gaining these current value data or power generation quantity data; applying a grey system predictive theory to the gained data, specifically, calculating an absolute degree of grey incidence from the gained data, using a digital grey predictive model to calculate, from the calculated absolute degree of grey incidence, the degree of incidence (degree of relevance) between data at present on the prediction target and data at present on the comparative target, and the degree of incidence between future data on the prediction target and future data on the comparative target; and then indicating a future timing when the degree of incidence between the future data will have been lowered by a specific level from the degree of incidence between the data at present. Thus, the present invention has been accomplished.

Thus, the present invention has created a method for predicting a future timing when the current value or power generation quantity of a solar cell module, solar cell string or power conditioner will have been lowered by a specific level from the current value or power generation quantity thereof at present, wherein the solar cell module, solar cell string or power conditioner is out of the entire modules, strings, and power conditioners in a solar power generation system including a plurality of power conditioners in each of which a plurality of solar cell strings each including a plurality of solar cell modules connected in series to each other are connected in parallel to each other, characterized in that the method includes: gaining data on the current value or power generation quantity of the solar cell module, solar cell string or power conditioner, which is a prediction target; gaining data on the current value or power generation quantity of a different and comparative solar cell module, solar cell string or power conditioner having one or more specific relevancies with the prediction target about a physically positional adjacent relationship, a physically positional interval relationship, a similarity of past data values, and/or a structural similarity, wherein the different and comparative solar cell module, solar cell string or power conditioner is out of the entire modules, strings, and power conditioners in the solar power generation system; calculating an absolute degree of grey incidence from these gained data; using a digital grey predictive model to calculate, from the calculated absolute degree of grey incidence, the degree of incidence between data at present on the prediction target and data at present on the comparative target, and the degree of incidence between future data on the prediction target and future data on the comparative target; and indicating a future timing when the degree of incidence between the future data will have been lowered by a specific level from the degree of incidence between the data at present, in the prediction target compared with the comparative target. In a preferred embodiment of the invention, the data gained are averaged over a predetermined period after the start of power generation, and over a predetermined period before the end of the power generation.

In a further preferred embodiment of the invention, the gained data may be averaged over a specific period.

In a further preferred embodiment of the invention, a prediction target may be indicated in which, from the present time to a future time after elapse of a predetermined period, the degree of incidence between the future data will have been lowered by the specific level. Then optionally a notice of the indicated prediction target may be given through a screen display, an electronic mail communication or an alarm sound.

Advantages of the Invention

According to the method of the present invention, between the prediction target module/string/power conditioner, and the module/string/power conditioner which tends to show similar data values to the prediction target module/string/power conditioner and which have a high relevancy with the prediction target module/string/power conditioner about the physical position, the past data value and the others, the transition of a fall in the degree of incidence between data on the power generation quantity or current value from the present to the future is observed, whereby it is possible to predict a future timing when an impermissible abnormality will be generated. The prediction makes it possible to advise an appropriate maintenance timing of the module/string/power conditioner of the solar power generation system precisely before the module/string/power conditioner is seriously troubled or remarkably lowered in power generation quantity. Furthermore, in the method of the present invention, the prediction is attained by using the grey system predictive theory; thus, the future timing of the generation of the impermissible abnormality of the solar power generation system can be predicted with very high precision, and the prediction is very simply attained.

Brief Description of the Drawings

Fig. 1 is an illustrative drawing of an example of a solar power generation system.
Fig. 2 shows a transition with time of the current values of a prediction target module and a module having a specific relevancy with the prediction target module.
Fig. 3 shows a transition with time of the degree of incidence between the prediction target module and the comparative target module, wherein this degree of incidence is calculated using the data in Fig. 2.
Fig. 4 shows a transition with time of the power generation quantities of a prediction target string and a string having a specific relevancy with the prediction target module.
Fig. 5 shows a transition with time of the degree of incidence between the prediction target string and the comparative target string, wherein this degree of incidence is calculated using the data in Fig. 4.
Fig. 6 shows a transition with time of the power generation quantities of a prediction target power conditioner and a power conditioner having a specific relevancy with the prediction target power conditioner.
Fig. 7 shows a transition with time of the degree of incidence between the prediction target power conditioner and the comparative target power conditioner, wherein this degree of incidence is calculated using the data in Fig. 6.

Mode for Carrying Out the Invention

A method of a solar power generation system of the present invention will now be illustrated below with reference to Figures although the present invention is not limited thereto. Absolute-degree-grey-incidence calculations, and digital-grey-predictive-model applications that will be described herein are merely examples. Thus, such calculations and applications in the present invention are not limited thereto.

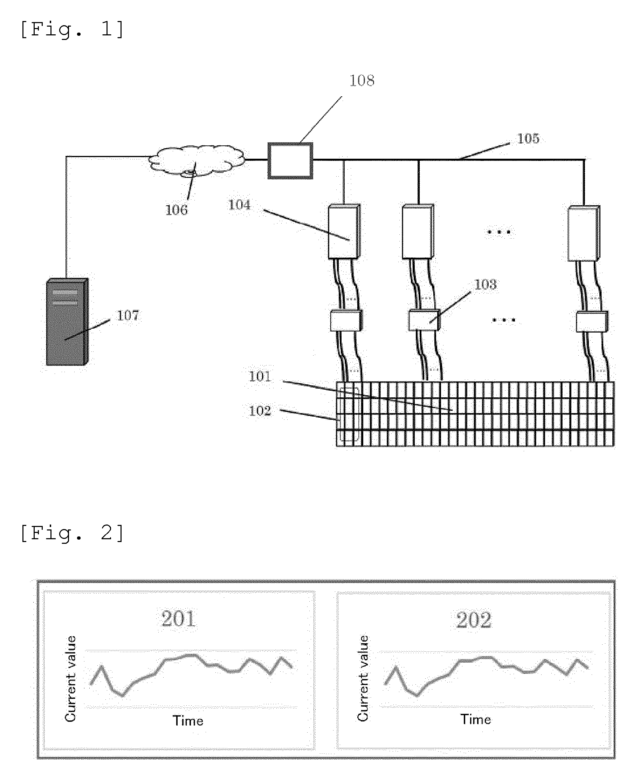

The solar power generation system to which the method of the present invention is applied is a system as illustrated in FIG. 1, which has a plurality of solar cell strings 102 in each of which a plurality of solar cell modules 101 are connected in series to each other. The plurality of the solar cell strings 102 are connected in parallel to each other to be concentrated through each connector box unit 103. The plurality of the connector boxes are then concentrated into each power conditioner 104. The power conditioners 104 constitute a single power generating site. These power conditioners are linked to each other through a network 105 to be concentrated into a data logger 108. Data on the current value or the power generation quantity measured in each of the modules/strings/power conditioners are collected through the data logger 108 and the Internet 106 into a data monitoring system server 107. The method of the present invention predicts, with a high precision, a timing of the generation of an impermissible future abnormality (timing when an abnormality will been have enlarged) in any one of the modules/strings/power conditioners of the solar power generation system.

The method of the present invention is usable in systems from small-scale systems each set up on the roof of a home housing to large-scale systems (mega solar systems) each giving a power generation quantity of 1 megawatt or more. The method is very useful for the mega solar systems because, in the mega solar systems, a very large number of modules/strings/power conditioners are set and very much labor is required for works for checking the modules or strings. It is necessary, in particular, for the mega solar system to receive a maintenance at an appropriate timing before a serious abnormality is generated therein in the future. The method of the present invention is very useful as means for advising an appropriate future timing of this maintenance.

The solar power generation system to which the method of the present invention is applied is not particularly limited as far as the number of modules per one string is plural, as far as the number of strings per one power conditioner is plural, and as far as the number of power conditioners in the system is plural. In the method of the present invention, it is preferred that the number of modules per one string is from 3 to 100, that the number of strings per one power conditioner is from 3 to 10000, and that the number of power conditioners in one system is from 3 to 1000. In the method of the present invention, it is preferred that individual solar cell modules/strings/power conditioners used in the system have the same structure type to each other in order to extract degree of incidence between the measured data on the current values or power generation with high precision.

As the causes for a lowering in the power generation quantity (current value) of any one of the solar cell modules/strings/power conditioners, there exist temporary causes, which may be ignored, and lasting causes, which are required to be repaired or exchanged. The temporary causes include hours of daylight, the existence of clouds, rainy weather, and other weather factors; a shadow of a building; a periodic maintenance thereof; and others. The lasting causes include a trouble of the solar cell module, a trouble of a measuring device or communication means therefor, droppings of birds, deficiencies in soldering/screw connection in power conditioner etc., trouble of inverter, salty fog, deficiencies in contact due to moisture erosion, and others.

The inventors have found out that the respective power generation quantities (current values) of these modules/strings/power conditioners, as well as lowered degrees of the quantities that result from the above-mentioned temporary causes and continual causes, have similar numerical value tendencies to each other about not only values in the past and at present but also values in the future between modules/strings/power conditioners having a specific high relevancy about a physically positional adjacent relationship, a physically positional interval relationship, a similarity of measured data on past power generation quantity (current value) and others, or a structural kind, out of the entire modules/strings/power conditioners; and that the tendencies are diluted when these modules/strings/power conditioners are seriously troubled or undergo many abnormalities, so that a mutual degree of incidence will lower. The inventors have then found out that a timing when a serious future abnormality will be generated with a high possibility or a longest future period until such a serious abnormality will be occurred can be precisely indicated by: calculating an absolute degree of grey incidence concerning data on the power generation quantities (current values) of these modules/strings/power conditioners; next applying a digital grey predictive model to the data to calculate the degree of incidence between data at present and the degree of incidence between data in the future; and extracting a future timing when the degree of incidence between the future data will have been lowered by a specific level from that between the data at present. The present invention is based on these findings. Only by setting up a lowered level of the degree of incidence, it will be possible to advise precisely a plan of an appropriate maintenance timing of the solar power generation system before the power generation quantity is lowered by the generation of many abnormalities, or before a serious trouble is generated.

In the method of the present invention, it first selects a prediction target module/string/power conditioner in which data on the current value or the power generation quantity is to be gained, and a different comparative target module/string/power conditioner from the entire modules/strings/power conditioners. At this time, the prediction target modules/strings/power conditioners and comparative target modules/strings/power conditioners need to have one or more specific relevancies about a physically positional adjacent relationship, a physically positional interval relationship, a similarity of past data values, and/or a structural similarity. A single module or plural modules of the entire modules are usable as such comparative targets.

The physically positional adjacent relationship means an adjacent relationship in physical position between the modules, strings or power conditioners, and can be set up in accordance with various definitions. For example, about the modules, the relevancy is set up in accordance with whether or not located physical positions of the modules are adjacent to each other about sides of the modules in the longitudinal direction or short direction thereof, or an oblique direction to the modules. When the modules are adjacent to each other in their sides extending in the longitudinal direction, the relevancy therebetween is highest. When the modules are adjacent to each other in their sides extending in the short direction, the relevancy is second highest. When the modules are adjacent to each other in the oblique direction, the relevancy is third highest. When the modules are not located at any one of these adjacent positions, it is concluded that the modules have no relevancy in terms of physically positional adjacent relationship. The physically positional adjacent relationship between the strings is determined in the same way as that between the modules. The same relationship between the power conditioners is determined merely in accordance with whether or not the power conditioners are adjacent to each other.

Through the physically positional interval relationship, the height (degree) of the relevancy is determined in accordance with the interval (distance) between the modules, strings or power conditioners. The interval (distance) can be set up in accordance with various definitions. The interval can be determined, for example, in accordance with the distance between the respective centers of the modules, strings or power conditioners, or may be determined as a minimum distance between the respective edges of the modules, strings or power conditioners.

The similarity of past data values means, about the power generation quantities (current values) of the modules, strings or power conditioners, a similarity between respective numerical values thereof in a predetermined period in the past. The similarity can be set up in accordance with various definitions. For example, in a predetermined period in the past, data on the power generation quantities (current values) are gained. In accordance with a similarity of the numerical values between these data (for example, the percentage of the approximation of one of the two data values to the other data value), the height (degree) of the relevancy is determined. When plural data are gained, the data may be averaged.

The structural similarity means a similarity in structure between the modules, strings, or power conditioners. The similarity can be set up in accordance with various definitions. In accordance with, for example, whether or not the two to be compared have an identity in structure, the height (degree) of the relevancy is determined.

As described above, in the method of the present invention, a comparative target module/string/power conditioner having a specific relevancy with a prediction target is extracted, and then data on the current values or power generation quantities of the prediction target module/string/power conditioner and data on the current values or power generation quantities of the comparative target module/string/power conditioner are gained. Concerning these gained data, an absolute degree of grey incidence is calculated on the basis of a grey system predictive theory. Next, a digital grey predictive model is applied to the absolute degree of grey incidence to calculate the degree of incidence between data at present on the prediction target and data at present on the comparative target, and the degree of incidence between future data on the prediction target and future data on the comparative target. When plural comparative targets exist for a single prediction target, such a degree of incidence is calculated relatively to data on each of the comparative targets, or is calculated relatively to the average of the respective data on the comparative targets.

The methods of calculating the absolute degree of grey incidence, and applying the digital grey predictive module are known in the prior art. Basically, in accordance with a numerical expression as described below, an absolute degree of grey incidence $\varepsilon_{1i}$ is gained. Next, a numerical expression of a digital grey predictive model DGM (1,1) is used under a condition of $\varepsilon = X$ to calculate the degree of incidence between data at present on the prediction target and data at present on the comparative target, and the degree of incidence between future data on the prediction target and future data on the comparative target. Next, the proportion of a lowering in the degree of incidence in the future from the degree of incidence at present is calculated. A future timing when the lowering proportion will have reached to a specific level is indicated. Alternatively, in a period from the present time to a future time after elapse of a predetermined time, a prediction target in which the lowering proportion will have reached to a specific level is indicated. Optionally, a notice of the indicated prediction target is given through a display on a monitor or any other screen, an electronic mail communication, or an alarm sound.

The absolute degree of grey incidence is calculated, using the following definition of the absolute degree of grey incidence $\varepsilon_{1i}$ between two sets $s_1$ and $s_i$:

$$\varepsilon_{1i} = \frac{1 + |s_1| + |s_i|}{1 + |s_1| + |s_i| + |s_i - s_1|}$$

wherein $s_1$ represents data on the prediction target, and $s_i$ represents data on the comparative target.

A digital grey predictive model is as follows (calculation expression of DGM (1,1)):

$$\beta_1 = \frac{\sum_{k=1}^{n-1} X^{(1)}(k+1)X^{(1)}(k) - \left\{\sum_{k=1}^{n-1} X^{(1)}(k+1)\right\}\left\{\sum_{k=1}^{n-1} X^{(1)}(k)\right\}/(n-1)}{\left\{\sum_{k=1}^{n-1} X^{(1)}(k)\right\}^2 - \left\{\sum_{k=1}^{n-1} X^{(1)}(k)\right\}^2/(n-1)}$$

$$\beta_2 = \frac{\sum_{k=1}^{n-1} X^{(1)}(k+1) - \beta_1\left\{\sum_{k=1}^{n-1} X^{(1)}(k)\right\}}{(n-1)}$$

$$\hat{X}^{(1)}(k+1) = \beta_1^k\left\{X^{(0)}(1) - \beta_2/(1-\beta_1)\right\} + \beta_2/(1-\beta_1)$$

$$\hat{X}^{(0)}(k+1) = \hat{X}^{(1)}(k+1) - \hat{X}^{(1)}(k)$$

The above-mentioned expressions for $\beta_1$ and $\beta_2$ are intermediate expressions; the value $\hat{X}^{(1)}(k+1)$ is a recursive value at a time "k +1"; and the value is a reduction predictive value at the time "k +1".

The following will demonstrate a specific example in which the above-mentioned absolute degree of grey incidence and digital grey predictive model were used to calculate the degree of incidence at present and the degree of incidence in the future. Initially, in a solar power generation system in which modules are arranged into a grid pattern, a single (rectangular) prediction target module, and two modules which are each adjacent to one of the long sides of the prediction target module and having the same structure are selected from the entire modules. Data including from data at a past time to data at present are gained on the respective current values of these modules. Fig. 2 is a graph showing a transition with time of the current value of the single prediction target, and a transition with time of the average current value of the two comparative targets. Its vertical axis represents current value; and its transverse axis represents time. In Fig. 2, a half region 201 shows data on the current value of the prediction target module; and a half region 202 shows data on the average current value of the comparative target modules. As is understood from Fig. 2, the respective transitions with time of the data in the regions 201 and 202 are very similar to each other.

These data are used to calculate the above-defined absolute degree of grey incidence. The current value of the prediction target at, for example, a time "k" represents $s_1(k)$; and the current value of the comparative targets at the time "k" represents $s_i(k)$. The degree of incidence $\varepsilon_{1i}(k)$ at the time "k" is calculated in accordance with the following expression:

$$\varepsilon_{1i}(k) = \frac{1 + |s_1(k)| + |s_i(k)|}{1 + |s_1(k)| + |s_i(k)| + |s_i(k) - s_1(k)|}$$

Next, the digital grey predictive model DGM (1,1) is used to calculate, from the gained absolute degree of grey incidence, the degree of incidence between data at present on the prediction target and data at present on the comparative target, and the degree of incidence between future data on the prediction target and future data on the comparative target. Specifically, $\varepsilon_{1i}(k)$ calculated at a time "n" represents $X^{(0)}(k)$, and then $X^{(1)}(k)$ is calculated in accordance with the expression $\hat{X}^{(1)}(k) = \sum_{k=1}^{n-1} \hat{X}^{(0)}(k)$. Thereafter, the calculated value is inserted into the above-mentioned DGM(1,1) expression to gain a future degree of incidence $\hat{X}^{(0)}(k+1)$ predicted at a time "n + 1". A time "n" represents the present time; and the time "n +1" represents a future time. Such a recursive calculating method makes it possible in the same way to calculate a future degree of incidence predicted at each of future times "n + 2" and "n + 3". The time interval between the individual times can be beforehand set, and may be set to an interval in the unit of, for example, an hour, a day, a week or a month. In this way, the degree of incidence between the data at present can be gained, and the degree of incidence between data at each future time that will be gained at a desired constant interval after the present time can be gained. Then, the following timing can be indicated: a future timing when the degree of incidence between the future data will have been lowered by a specific level from the degree of incidence between the data at present, in the prediction target compared with the comparative target. Alternatively, about plural prediction targets out of entire modules, in a period from the present time to a future time after elapse of a predetermined time, the degree of incidence between data at present and the degree of incidence between data in the future are gained about the prediction targets, and a comparative target out of the entire modules; and then, the following prediction target can be indicated from the entire prediction targets: a prediction target having a degree of incidence between the data in the future that will have been lowered by a specific level from the degree of incidence between the data at present.

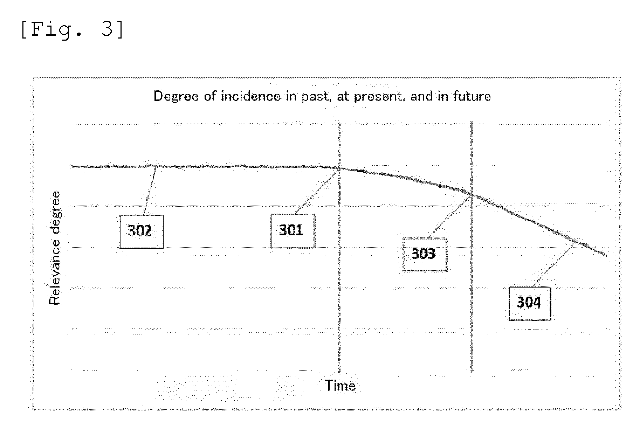

Fig. 3 shows the respective degree of incidences between the data in the past, at present and in the future on the prediction target and the comparative targets, wherein these degrees were calculated using the data on the modules in Fig. 2. In Fig. 3, its vertical axis represents degree of incidence. In the case of a degree of incidence showing a complete consistency, the value thereof is one. Its transverse axis represents time. A point 301 shows the degree of incidence between the data at present; a line 302 shows the degree of incidence between the data in the past; and a line 304 shows the degree of incidence between the data in the future. A point 303 represents a future timing when there will be generated future data having a degree of incidence that will have been lowered by 15% from the degree of incidence between the data at present. As is understood from Fig. 3, the degree of incidence between the data tends to be lowered as time elapses from the present time to the future. When the degree of incidence between the data in the future will have been lowered by a specific level from the degree of incidence between the data at present, the following possibility will be heightened: the possibility of causing an impermissible serious trouble or a problem of a lowering in the current value of the module by the generation of many abnormalities. Accordingly, the level of the degree of incidence at present could be beforehand set as normal status. By showing a future timing when a predetermined level of lowering will be generated, a future appropriate maintenance timing of the module can be precisely indicated at present. When this future timing is indicated in this way, the level of the lowering from the degree of incidence between the data at present to the degree of incidence between the data in the future may be set to 1% or more, 2% or more, 3% or more, 4% or more, 5% or more, 6% or more, 7% or more, 8% or more, 9% or more, 10% or more, 12% or more, 15% or more, or 20% or more. When the lowering level is set to, for example, 15% or more, it is possible to advise that the future timing shown by the point 303 is a future appropriate maintenance timing of the module.

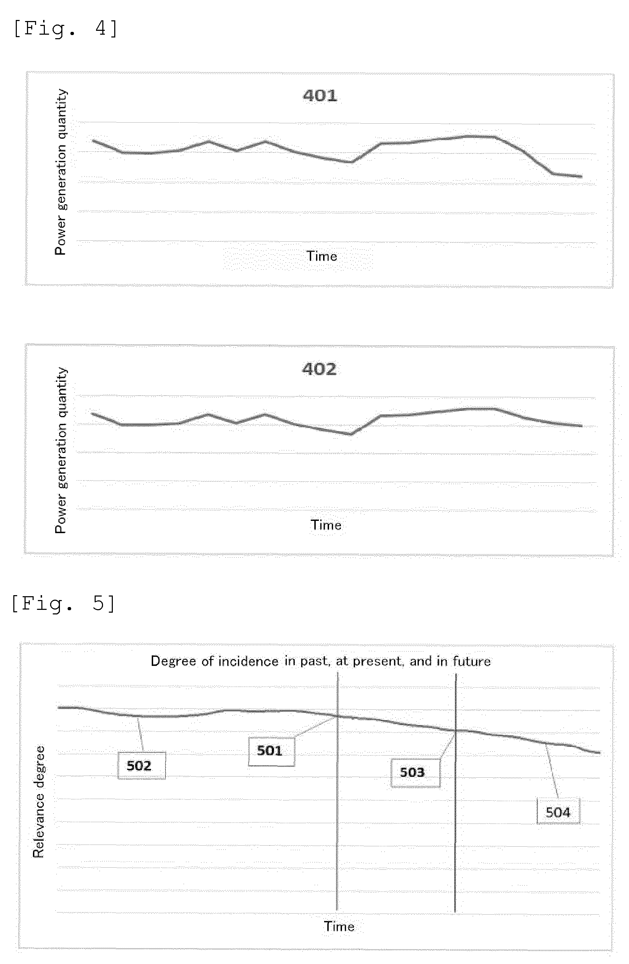

The following will demonstrate a specific example in which: in a solar power generation system having strings arranged in a grid pattern, a single prediction target string and a single comparative target string having the same structure as the prediction target string and is nearest to the prediction target string in terms of distance were selected from the entire strings; data including from a past time to present were gained on the respective power generation quantities of these strings; and then an absolute degree of grey incidence and digital grey predictive model DGM (1,1) as described above were used to calculate the degree of incidence between data at present on the prediction target and data at present on the comparative target, and the degree of incidence between future data on the prediction target and future data on the comparative target. Fig. 4 shows a transition with time of the power generation quantity of the single prediction target string, and a transition with time of the power generation quantity of the single comparative target string. Its vertical axis represents power generation quantity; and its transverse axis represents time. In Fig. 4, a region 401 shows data on the power generation quantity of the prediction target string; and a region 402 shows data on the power generation quantity of the comparative target string. Fig. 5 shows the respective degree of incidence between the data in the past, at present and in the future on the prediction target and the comparative targets, wherein these degrees were calculated using the data on the strings in Fig. 4. In Fig. 5, its vertical axis represents degree of incidence. In the case of a degree of incidence showing a complete consistency, the value thereof is one. Its transverse axis represents time. A point 501 shows the degree of incidence between the data at present; a line 502 shows the degree of incidence between the data in the past; and a line 504 shows the degree of incidence between the data in the future. A point 503 represents a future timing when there will be generated future data having a degree of incidence that will have been lowered by 8% from the degree of incidence between the data at present. As is understood from Fig. 5, the degree of incidence between the data tends to be lowered as time elapses from the present time to the future. When the degree of incidence between the data in the future will have been lowered by a specific level from the degree of incidence between the data at present, the following possibility will be heightened: the possibility of causing an impermissible serious trouble or a problem of a lowering in the power generation quantities of the string by the generation of many abnormalities. Accordingly, the level of the lowering from the degree of incidence between the data at present to the degree of incidence between the data in the future is beforehand set to a level at which no problem is caused. By showing a future timing when this lowering level will be generated, a future appropriate maintenance timing of the string can be precisely indicated at present. When the lowering level is set to, for example, 8% or more, it is possible to advise that the future timing shown by the point 503 is a future appropriate maintenance timing of the string.

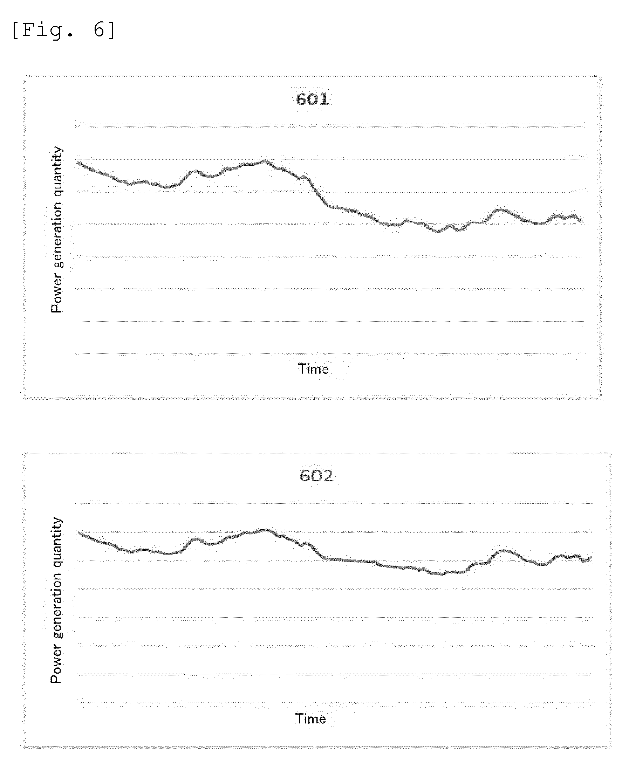

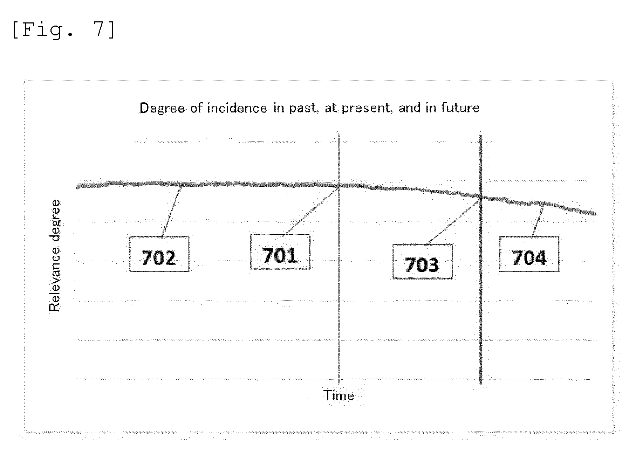

The following will demonstrate a specific example in which: in the same solar power generation system, a single prediction target power conditioner and a single comparative target power conditioner having the same structure as the prediction target power conditioner and having most similar transition of data on power generation quantities during one month in the past to the prediction target power conditioner were selected out of the entire power conditioners; data including from data at a past time to data at present were gained on the respective power generation quantities of these power conditioners; and then an absolute degree of grey incidence and digital grey predictive model DGM (1,1) as described above were used to calculate the degree of incidence between data at present on the prediction target and data at present on the comparative target, and the degree of incidence between future data on the prediction target and future data on the comparative target. Fig. 6 shows a transition with time of the power generation quantity of the single prediction target power conditioner, and a transition with time of the power generation quantity of the single comparative target power conditioner. Its vertical axis represents power generation quantity; and its transverse axis represents time. In Fig. 6, a region 601 shows data on the power generation quantity of the prediction target power conditioner; and a region 602 shows data on the power generation quantity of the comparative target power conditioner. Fig. 7 shows the respective degree of incidence between the data of power conditioner in the past, at present and in the future on the prediction target and the comparative targets, wherein these degrees were calculated using the data on the power conditioners in Fig. 6. In Fig. 7, its vertical axis represents degree of incidence. In the case of a degree of incidence showing a complete consistency, the value thereof is one. Its transverse axis represents time. A point 701 shows the degree of incidence between the data at present; a line 702 shows the degree of incidence between the data in the past; and a line 704 shows the degree of incidence between the data in the future. A point 703 represents a future timing when there will be generated future data having a degree of incidence that will have been lowered by 6% from the degree of incidence between the data at present. As is understood from Fig. 7, the degree of incidence between the data tends to be lowered as time elapses from the present time to the future. When the degree of incidence between the data in the future will have been lowered by a specific level from the degree of incidence between the data at present, the following possibility will be heightened: the possibility of causing an impermissible serious trouble or a problem of a lowering in the power generation quantity of the power conditioner by the generation of many abnormalities. Accordingly, the level of the degree of incidence at present could be beforehand set as normal status. By showing a future timing when a predetermined level of lowering will be generated, a future appropriate maintenance timing of the power conditioner can be precisely indicated at present. When the lowering level is set to, for example, 6% or more, it is possible to advise that the future timing shown by the point 703 is a future appropriate maintenance timing of the power conditioner.

In the method of the present invention, in order to decrease the effect of a variation in power generation quantity (current value) data between a time after the start of power generation and a time before the end thereof, it is possible to average data on the power generation quantity (current value) that are gained in any module/string/power conditioner, over a predetermined period (for example, a period from 10 minutes to 1 hour) after the start of the power generation, as well as over a predetermined period before the end of the power generation (for example, a period from 10 minutes to 1 hour). Alternatively, in order to cancel the effect of the variation in the data in these periods, it is permissible to exclude the use of the data on the power generation quantity (current value) in the predetermined period after the start of power generation and on the power generation quantity (current value) in the predetermined period before the end of the power generation.

In the method of the present invention, in order to decrease the effect of a remarkable variation in power generation quantity (current value) data in any period except the period after the start of power generation and that before the end thereof, it is possible to average, over a specific period, data on the power generation quantity (current value) gained in any module/string/power conditioner. Alternatively, in order to cancel the effect of the remarkable variation in these data, it is permissible to exclude the use of data on the power generation quantity (current value) in these periods.

In the method of the present invention, it is preferred to arrange a measuring device for measuring a current value or voltage value to each module/string/power conditioner. The power generation quantity can be calculated by multiplying the measured current value by the measured voltage value. The measuring device may be a measuring device known in the prior art. The current-value-measuring device may adopt, for example, a mode of measuring the current value by a method of putting a resistance for measurement in series to a site to be measured, and converting the current value to volts at both ends of the resistance. The current value and other data measured by the measuring device are collected through, for example, cable or wireless communication means, and then a computer known in the prior art is used to calculate a degree of incidence as described above, and to indicate a future timing as described above, or others. The indication (display or notification) can be attained by a screen display in a liquid crystal or LED display device, an electronic mail communication using the Internet, or the generation of an alarm sound through an audio system such as a speaker.

Industrial Applicability

The method of the present invention makes it possible to advise an appropriate maintenance timing precisely before a solar power generation system will be seriously troubled or remarkably lowered in power generation quantity in the future. Thus, the solar power generation system can be efficiently used or operated over a long term. As a result, the method of the present invention increases power generation quantity, lengthens the use-span of the facilities, and further produces an eco-advantage based on an improvement in sunlight use-efficiency. Thus, the present invention is very useful. Explanation of Reference Number

101:    solar cell module
102:    solar cell string
103:    power collecting terminal unit
104:    power conditioner
105:    network
106:    Internet
107:    data monitoring system server
108:    data logger
201:    data on the current value of the prediction target
202:    data on the average current value of the comparative target
301:    degree of incidence between the data at present
302:    degree of incidence between the data in the past
303:    future timing when there will be generated future data having a degree of incidence that will have been lowered by 15% from the degree of incidence between the data at present
304:    degree of incidence between the data in the future
401:    data on the power generation quantity of the prediction target
402:    data on the power generation quantity of the comparative target
501:    degree of incidence between the data at present
502:    degree of incidence between the data in the past
503:    future timing when there will be generated future data having a degree of incidence that will have been lowered by 8% from the degree of incidence between the data at present
504:    degree of incidence between the data in the future
601:    data on the power generation quantity of the prediction target
602:    data on the power generation quantity of the comparative target
701:    degree of incidence between the data at present
702:    degree of incidence between the data in the past
703:    future timing when there will be generated future data having a degree of incidence that will have been lowered by 6% from the degree of incidence between the data at present
704:    degree of incidence between the data in the future

**Claims**

1.  A method for predicting a future timing when the current value or power generation quantity of a solar cell module, solar cell string or power conditioner will have been lowered by a specific level from the current value or power generation quantity thereof at present, wherein the solar cell module, solar cell string or power conditioner is out of the entire modules, strings, and power conditioners in a solar power generation system including a plurality of power conditioners in each of which a plurality of solar cell strings each including a plurality of solar cell modules connected in series to each other are connected in parallel to each other, **characterized in that** the method includes:

    - gaining data on the current value or power generation quantity of the solar cell module, solar cell string or power conditioner, which is a prediction target;
    - gaining data on the current value or power generation quantity of a different and comparative solar cell module, solar cell string or power conditioner having one or more specific relevancies with the prediction target about a physically positional adjacent relationship, a physically positional interval relationship, a similarity of past data values, and/or a structural similarity, wherein the different and comparative solar cell module, solar cell string or power conditioner is out of the entire modules, strings, and power conditioners in the solar power generation system;
    - calculating an absolute degree of grey incidence from these gained data;
    - using a digital grey predictive model to calculate, from the calculated absolute degree of grey incidence, the degree of incidence between data at present on the prediction target and data at present on the comparative target, and the degree of incidence between future data on the prediction target and future data on the comparative target;
    - and indicating a future timing when the degree of incidence between the future data will have been lowered by a specific level from the degree of incidence between the data at present, in the prediction target compared with the comparative target.

2.  The method according to claim 1, wherein the data gained are averaged over a predetermined period after the start of power generation, and over a predetermined period before the end of the power generation.

3. The method according to claim 1 or 2, wherein the gained data are averaged over a specific period.

4. The method according to any one of claims 1 to 3, wherein a prediction target is indicated in which, from the present time to a future time after elapse of a predetermined period, the degree of incidence between the future data will have been lowered by the specific level.

5. The method according to claim 4, wherein then a notice of the indicated prediction target is given through a screen display, an electronic mail communication or an alarm sound.

[Fig. 1]

[Fig. 2]

[Fig. 3]

[Fig. 4]

[Fig. 5]

[Fig. 6]

601

Power generation quantity

Time

602

Power generation quantity

Time

EP 3 059 856 A1

[Fig. 7]

Degree of incidence in past, at present, and in future

Relevance degree

702 701 703 704

Time

16

Europäisches
Patentamt

European
Patent Office

Office européen
des brevets

# EUROPEAN SEARCH REPORT

Application Number

EP 16 15 5517

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LI YANBIN ET AL: "Short-term prediction of the output power of PV system based on improved grey prediction model", PROCEEDINGS OF THE 2014 INTERNATIONAL CONFERENCE ON ADVANCED MECHATRONIC SYSTEMS, IEEE, 10 August 2014 (2014-08-10), pages 547-551, XP032652290, DOI: 10.1109/ICAMECHS.2014.6911606 [retrieved on 2014-09-25] * the whole document * | 1-5 | INV. H02S50/00 |
| X | CN 103 500 365 A (GUANGZHOU POWER SUPPLY BUREAU; UNIV NORTH CHINA ELEC POWER) 8 January 2014 (2014-01-08) * the whole document * | 1-5 | |
| A | BIN XU ET AL: "Application of grey system theory to MTPV system optimization", ADVANCED MECHATRONIC SYSTEMS (ICAMECHS), 2011 INTERNATIONAL CONFERENCE ON, IEEE, 11 August 2011 (2011-08-11), pages 260-264, XP031940502, ISBN: 978-1-4577-1698-0 * the whole document * | 1-5 | |

TECHNICAL FIELDS
SEARCHED      (IPC)

H02S

The present search report has been drawn up for all claims

| Place of search | Date of completion of the search | Examiner |
|---|---|---|
| The Hague | 16 June 2016 | Boero, Mauro |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 16 15 5517

This annex lists the patent family members relating to the patent documents cited in  the above-mentioned European search report.
The members are as contained in the European Patent Office EDP file on
The European Patent Office is in no way liable for these particulars which are merely given for the purpose of information.

16-06-2016

| Patent document cited in search report | | Publication date | Patent family member(s) | Publication date |
|---|---|---|---|---|
| CN 103500365 | A | 08-01-2014 | NONE | |

EPO FORM P0459

**REFERENCES CITED IN THE DESCRIPTION**

**Patent documents cited in the description**

- WO 2011101916 A1
- JP 2013093430 A
- JP 2012156343 A
- WO 2012081116 A1